# EUROPEAN PATENT SPECIFICATION

(11) **EP 1 714 479 B1**
(45) Date of publication and mention of the grant of the patent: **16.04.2008**
(21) Application number: 05702832.6
(22) Date of filing: 28.01.2005
(51) Int. Cl.: H04N 5/445

(54) **METHOD FOR CUSTOMIZING A USER INTERFACE FOR SELECTING BROADCAST SOURCES**
VERFAHREN ZUR ANPASSUNG EINER BENUTZEROBERFLÄCHE ZUR AUSWAHL VON BROADCAST-QUELLEN
PROCEDE POUR PERSONALISER UNE INTERFACE D'UTILISATEUR POUR LA SELCTION DE SOURCES DE RADIODIFFUSION

(30) Priority: 02.02.2004 EP 04100368
(43) Date of publication of application: 25.10.2006
(73) Proprietor: Koninklijke Philips Electronics N.V., 5621 BA Eindhoven (NL)
(72) Inventor: MUSSCHEBROECK, Rudy, NL-5656 AA Eindhoven (NL); THISSEN, Rogier, L., J., W., NL-5656 AA Eindhoven (NL); PEIFFER, Werner, P., NL-5656 AA Eindhoven (NL); HINTZEN, Reinhard, L., NL-5656 AA Eindhoven (NL)
(74) Representative: van der Veer, Johannis Leendert
(86) International application number: PCT/IB2005/050381
(87) International publication number: WO 2005/074263

(56) References cited:
- EP-A- 0 601 554
- WO-A-00/17738
- WO-A-01/54406
- US-A1- 2003 037 335
- US-A1- 2003 103 088

## Description

### FIELD OF THE INVENTION

The invention relates to providing a service to a consumer, preferably via a data network such as the Internet. More particularly, the invention relates to a method of configuring a device for an end user.

### BACKGROUND ART

Typically, subscribers to cable TV or satellite TV receive broadcasts from a plurality of TV stations (e.g., BBC1, BBC2, NED1, NED2, ARD, ZDF, TF1, FR2, ...) via their cable or satellite set top box. The cable or satellite operator assigns to each station a part of the bandwidth on the transmission medium (e.g., part of the spectrum on a coaxial cable). These bandwidth portions are called channels, and are identified by channel numbers. In order to watch the programs broadcasted by a particular station, a TV's tuner must tune to the correct frequency (range) or bandwidth portion, i.e., the correct channel.

In the US, channel numbers of the broadcast stations are fixed. That is, the user cannot change the channel number that goes with a certain station. In Europe the situation is different: European television sets allow the user to associate an arbitrary channel number (from 0 to a maximum value, e.g. 99) to a specific station. That is, the station's signal still occupies a given fixed portion of the spectrum, but the user can choose the channel number that identifies that portion for local processing.

Touch-screen remote control devices (e.g., the Pronto of Philips) have a display monitor with a touch screen. For background on touch screen remote control devices, see, e.g., US patent 6,208,341 "GUI OF REMOTE CONTROL FACILITATES USER-FRIENDLY EDITING OF MACROS" (Attorney docket PHA 23,470) and US patent 5,956,025 "REMOTE WITH 3D-ORGANIZED GUI FOR A HOME ENTERTAINMENT SYSTEM" (Attorney docket PHA 23,248), both incorporated herein by reference. The monitor displays control buttons (soft keys) that can be interacted with through the touch screen. The keys can be organized so that the monitor displays pages of clusters of buttons. The buttons per page then facilitate operational use of the remote control device, as buttons typically used together are made accessible in a single page, thus reducing the amount of navigation in the menu.

For channel selection a specific page accommodates control buttons that, e.g., represent the digits used to identify the proper channel. Pressing these buttons causes control commands to be transmitted to the receiving apparatus (e.g., a TV of a set-top box) in order to make the built-in tuner tune to the channel thus selected. Depending on the channel selection mechanism implemented by the vendor, this may involve one, two, or three digits, an 'enter' key, a "-/--" key, a "100+' key, etc. This process may be lengthy and requires users to memorize station-channel number associations.

For an alternative, reference is made to Japanese Patent Application with Publication Number 09-322013 "REMOTE CONTROLLER OF ICON DISPLAY SYSTEM". This publication discloses a remote control system for a TV with a touch screen remote control unit. The display monitor of the remote control unit displays icon information for selecting a TV channel. The icon of the channel selected is also sent to the TV for being displayed on the TV's display monitor before the user's validating the selection. The company designing the application running at the remote and at the TV determines the icon's design.

For yet another representation, reference is made to European patent application EP 0 763 893 A1. This publication relates to a device for the selection of television signals, comprising means for the tuning of television signals, memory means for memorizing information for the relative tuning of preferred signals and an image display means with the possibility to visualize information so as to facilitate the selection of said preferred signals. The main characteristic of said device consists in the fact that said information is shown under the form of graphic symbols that represent the logotype normally used by the broadcasting station to identify itself. The majority of such icons will have already been memorized in a memory of the device in the place of manufacture or installation. It is however convenient to provide a special entrance for the introduction of new icons on the part of the user, when new broadcasting stations are activated, or stations already in existence changing their icon. Such an entrance can be provided in the control circuit. The use of special magnetic cards or a bar code reader, or other suitable systems can be used for the introduction of the icons. An alternative system, that would have the advantage of consenting an easy replacement or addition of icons, is that said icons are transmitted directly by the broadcasting station concerned, by a special teletext page. At this point the control circuit can be pre-arranged in order to be able to read it along with the televideo signal and to register it in the memory according to the users command, or even automatically.

Also, EP 0 601 554 discloses a device can be operated in two scanning modes. In the first scanning mode, all television channels are automatically searched in succession for receivable station signals and information on all stations found are stored in the station memory of the television receiver. The second scanning mode is distinguished by the fact that the pre-existing allocation of the station memory is retained and that information on newly found stations is stored in other storage locations of the station memory.

Furthermore, US 2003/037335 describes an interactive TV device is configured to receive and process multiple broadband input streams simultaneously. The device includes functionality to perform as a Web browser, HF, cable and satellite TV receiver, a digital PVR, an interactive TV set-top box, an advanced central processing unit and a videoconferencing device, thanks to an integrated videoconferencing camera. The present interactive TV device is configured to manage all multimedia sources identically, whether the input is a TV channel, a Web page, or a video stream played back from a data carrier such as a DVD, for example. The present interactive TV device is also configured to enable a user to watch and record a plurality of video streams simultaneously and to display them on four independently manageable quarter screen segments.

### SUMMARY OF THE INVENTION

The inventors have realized that above approaches have drawbacks. The first example above requires the end user to memorize the channels by their two-digit or three-digit channel number, which is rather cumbersome. The second example has the manufacturer provide different combinations of a remote control and TV set per broadcast service provider, and also forces the user to keep using the specific remote control with the same TV set. The third example requires the manufacturer or installer to program the logos of the channels relevant to the individual end user. The inventors therefore propose an approach more convenient to all parties involved: the consumer, the manufacturer and the installer.

To this end, the inventors propose a method of enabling to configure a device for enabling a user to select from among a plurality of sources that supply content. The method comprises determining the plurality of sources available to the user for operational use of the device. Respective representations of respective ones of the sources are determined for being rendered at a user interface. Then means is provided for configuring the device so that user interaction with a specific one of the representations rendered causes the device to select a specific one of the sources associated with the specific representation.

In an embodiment of the invention, the determining of the plurality of sources comprises determining respective identifiers, being local to the user, of respective ones of the plurality of the sources. The means is operative to associate the respective representations with the respective identifiers. The means comprises, e.g., a look-up table of associations of the respective local identifiers with the respective representations.

For example, the sources comprise a broadcast channel that has a channel number associated with it as the identifier. A representation associated with the channel number comprises a logo or call sign of the channel for being rendered on a touch screen of the user interface. Alternatively, a representation associated with the channel number is indicative of semantics of the content broadcast on the channel. User interaction with a particular call sign or semantic representation of the content causes the TV or radio to tune to the associated channel.

The channel numbers may be fixed (as in the US) or may be user-programmable (as in Europe). The user may indicate to which broadcast stations he/she has got access, and in addition (in Europe) which identifiers (channel numbers) he/she has assigned to the stations. The method of the invention then provides a look-up table that associates channel numbers with the proper logos or call signs, together with code for creating the logos or call signs in the user interface as a replacement for the channel numbers. Before installing the look-up table and code at the device, user interaction with the channel number causes the proper control commands to be sent to the source to be controlled, here a TV set or radio set. When the look-up table and code have been installed, user interaction with the call sign or logo triggers sending the control commands via the look-up table.

As illustrated with the examples above, an embodiment of the invention relates to a substitution of logos or call signs for channel numbers in order to facilitate user interaction. As an alternative, the complete configuring of the device could be delegated to a server. The means for configuring then includes software for the local recreation of the call signs or logos in the user interface and, in addition, the proper control codes (e.g., macros) for control of the sources (e.g., tuning to the proper channel). Within this context, see US pat. app. ser no. 09/519,546 (attorney docket US 000014) filed March 6, 2000, for Erik Ekkel et al., for "PERSONALIZING CE EQUIPMENT CONFIGURATION AT SERVER VIA WEB-ENABLED DEVICE", incorporated herein by reference and published under PCT as WO0154406. This patent document relates to facilitating the configuring of consumer electronics (CE) equipment by the consumer by means of delegating the configuring to an application server on the Internet. The consumer enters his/her preferences in a specific interactive Web page through a suitable user-interface of an Internet-enabled device (104), such as a PC or set-top box or digital cellphone. The application server generates the control data based on the preferences entered and downloads the control data to the CE equipment itself or to the Internet-enabled device.

### BRIEF DESCRIPTION OF THE DRAWING

The invention is explained in further detail, by way of example and with reference to the accompanying drawing wherein:
Figs. 1 and 5 are block diagrams of systems in the invention; and
Figs. 2, 3 and 4 are flow diagrams of a method in the invention.

Throughout the figures, same reference numerals indicate similar or corresponding features.

### DETAILED EMBODIMENTS

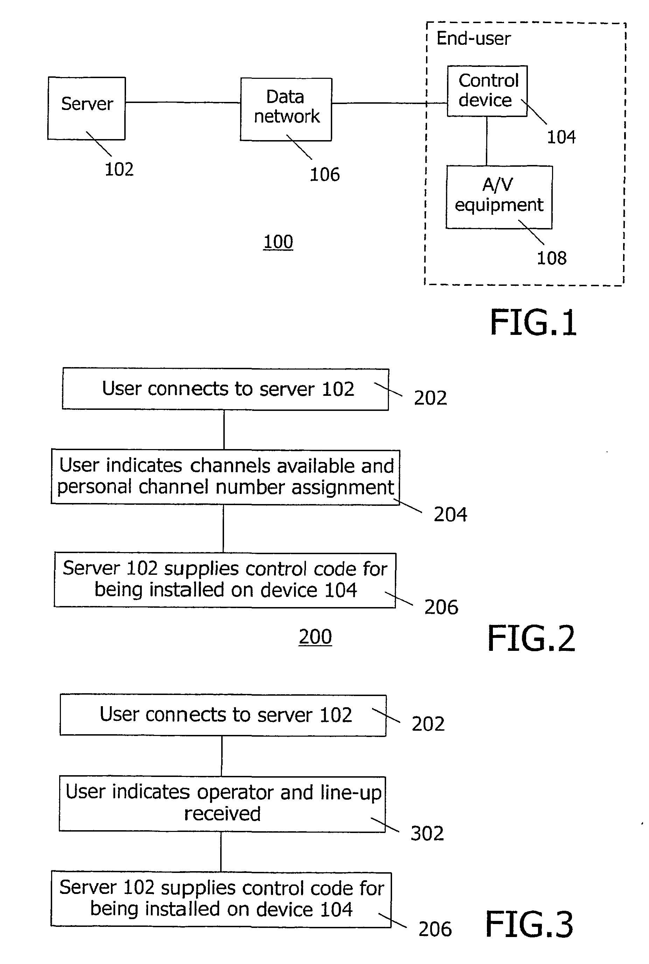

Fig. 1 is a block diagram of a system in the invention 100 comprising a server 102, a control device 104, a data network 106 such as the Internet, and audio/video (A/V) equipment 108. Device 104 has a user interface preferably with touch screen functionality. Device 104 can be connected to remote server 102 via data network 106 either directly (i.e., device 104 itself is network-enabled) or indirectly, e.g., via a network-enabled device (not-shown) such as a PC for download of data into device 104. Within this context, see for example, US App. Ser. No. 09/311,128 (Attorney docket PHA 23,501) filed May 13, 1999, for Joost Kemink for INTERNET-BASED SERVICE FOR UPDATING A PROGRAMMABLE CONTROL DEVICE, incorporated herein by reference and published under PCT as W00017738. This document relates to an Internet-based service for updating a programmable control device. An Internet site contains links to appliance-dependent control and feature option information which can be downloaded to the programmable control as a graphic user interface (GUI). A user interface is provided at the site for the user to easily specify a target appliance, and thereafter selectively download the interface and control information that is available for the target appliance. The Internet site also contains links to other providers of configurations and macros, such as system integrators who provide interfaces based on an inventory of the user's controllable equipment, hobbyist who share configurations and macros that they've found useful, and so on.

The end-user controls A/V equipment 108 via device 104. A/V equipment comprises, e.g., apparatus that receive content via a broadcast such as a TV set or a radio set. TV sets and radio sets can be tuned to various broadcast stations to receive diverse programs.

In order to facilitate selection of content from a variety of sources available to the end-user, the inventors propose to use graphical or pictorial representations at the user interface of device 104 of the sources, rather than a numerical representation (e.g., channel number) in a sequence covering the available sources as explained above. Graphical representations may comprise the logos or call signs of the broadcast stations. These then are used as soft buttons on the touch screen.

On a scale of further granularity, the representation may comprise a graphical or pictorial representation of the content being currently made available. Accordingly, rather than selecting content based on the broadcast source (e.g., TV channel or radio channel), the content is being selected based on its semantics. For example, pictorial representations of TV programs currently being broadcast on channels available to the end user in system 100 are made available as soft buttons on the touch screen of device 104. In order to provide a context to the user, the representations may be clustered, e.g., in different pages rendered on the touch screen. One page comprises the programs currently being broadcast organized according to channel, another page programs that are going to be broadcast next in a similar organization, etc. Other organizations and clusters may be used to facilitate user interaction and user control.

Figs. 2, 3 and 4 are flow diagrams 200, 300 and 400, respectively, illustrating aspects of the method of the invention. According to an aspect of the invention, a list of station call signs (or logos or other pictorial representations) is provided to represent the broadcast channels from which the individual end user in system 100 can select using his/her control device 104, e.g., a remote control device with a touch screen. In order for this to work for a given user, the station-channel number associations that apply to the individual user's situation need to be known. To this end, a service is provided that allows the user to go through a personalization process.

In flow diagram 200, the user connects to server 102 in a step 202, e.g., via a PC or directly via device 104 if the latter is network-enabled and provides a user interface that allows sending data via a network. In the event users can assign their own channel numbers (e.g., as in Europe) the user indicates in a step 204 what stations he/she receives and what channel numbers are to be used to identify the various stations. Once the user has provided this information, server 102 provides in a step 206 control code comprising the station/channel-number associations for this particular user, and possibly logos for display on the remote's touch screen, for being stored in an on-board database of device 104. When a user selects a station logo or call sign as rendered at device 104, the installed control code looks up the corresponding channel number in the on-board database and a macro is launched that sends commands (e.g., via IR) to A/V equipment 108 corresponding to the sequence of digits and other keys that causes equipment 108 to tune to the proper channel. The described method provides a convenient web-based way of associating TV line-up stations to channel numbers, which then allows more convenient control of tuning devices by means of a touch-screen remote control unit.

In flow diagram 300, the scenario is illustrated of fixed station/channel-number associations (e.g., as in the US). Steps 202 and 206 are similar to the ones in diagram 200. In the current scenario, the user selects his/her cable TV or satellite operator and the line-up that he/she receives: this determines the station/channel-number associations as these are fixed by the operator for every line-up. Accordingly, in a step 302 the user indicates who is the service operator and the line-up received.

Flow diagram 400 illustrates a further simplification that can be made for the European situation, by collecting postal delivery area codes and cable/satellite operator names from the user during the personalization process, and associating the user's station selection to the operator and area provided. Alternatively, it is sufficient to ask the user only for the postal delivery area code in a step 402 and let the user choose from a list of operators that provide a service in that area in a step 404. The station list will then be a given without the user having to go through a lengthy process of explicitly selecting all stations. As it is the user's initially providing this information himself this is a very cost-efficient way of collecting such data. The described methods provide a data collection mechanism for postal delivery area codes and cable/satellite operator names, in which users provide the data. This allows the party setting up the web-based service to collect data very cost-efficiently. For reference: In Europe, the sole pan-European data provider Luxemburg-based Infomedia, a Gemstar-owned company, provides Electronic Program Guide data. They have lists of stations available per country. However they do not have regional information (no information on operators for a given postal delivery area code, and local TV line up offering of that operator). Hence, the method of the invention could prove very useful.

On a scale of further granularity, the representation of the channel may comprise a graphical or pictorial representation of the content being currently made available. Accordingly, rather than selecting content based on the broadcast source (e.g., TV channel or radio channel), the content is being selected based on its semantics. These semantic representations are made available by, e.g., a service provider such as an electronic program guide (EPG) provider. Alternatively, these could be generated locally, e.g., by means of a spare TV tuner of the user's equipment for scanning the available channels and grabbing a frame representative of the program currently being broadcast. For example, pictorial representations of TV programs currently being broadcast, or going to be broadcast shortly, on channels available to the end user in system 100 are made available as soft buttons on the touch screen of device 104. In order to provide a context to the user, the representations may be clustered, e.g., in different pages rendered on the touch screen. One page comprises the programs currently being broadcast organized according to channel, another page programs that are going to be broadcast next in a similar organization, etc. Other organizations and clusters may be used to facilitate user interaction and user control. For this scenario to work, server 102 maintains a program guide per operator and provides graphical representations of the relevant programs preferably prepared in advance. These then are installed on device 104 representing the relevant channel for the duration of the associated program being broadcast. Accordingly, the user interface of device 104 resembles a cross section of an electronic program guide restricted to temporal aspects.

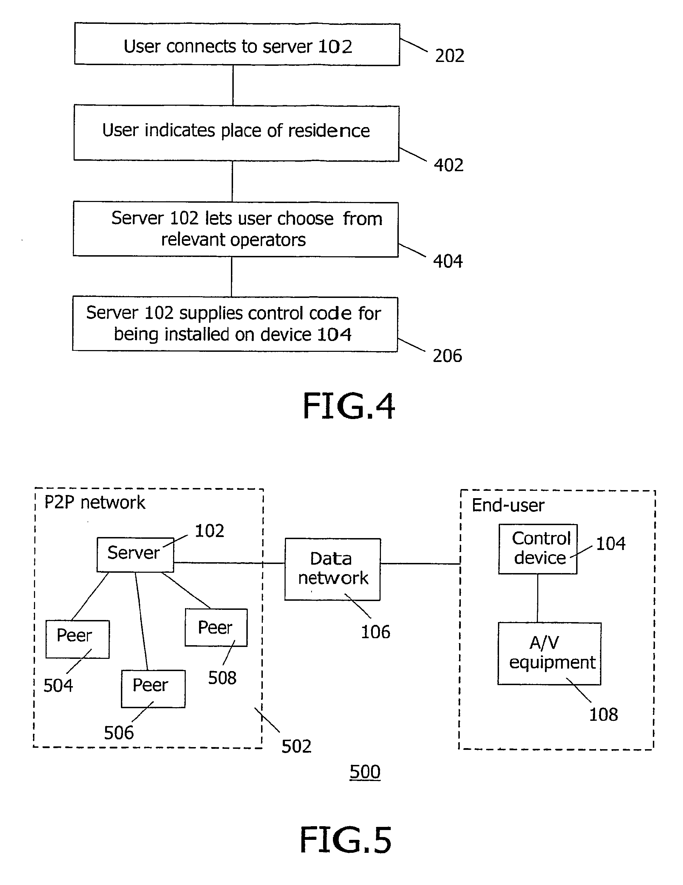

Fig. 5 is a block diagram of another system 500 in the invention. A/V equipment 108 may also comprise apparatus for accessing a peer-to-peer (P2P) network 502 of, e.g., video recorders. The term P2P refers to a type of transient (Internet) network that allows a group of users with the same networking program to connect with each other and directly access files from one another's data storage. Various P2P configurations exist, such as a centralized configuration, a decentralized configuration and a controlled centralized configuration. In a centralized configuration, the system depends on a central server that directs the communication between peers. "Napster" is an example of a centralized configuration. A decentralized configuration has not got a central server, and each peer is capable of acting as a client, as a server or as both. A user connects to the decentralized network by connecting to another user who is connected. "Gnutella" and "Kazaa" are examples of decentralized networks. In a controlled decentralized configuration a user may act as a client, as a server or as both as in the decentralized configuration, but specific operators control which user is allowed to access which particular server. "Morpheus" is an example of the latter. For a brief discussion of P2P network architectures see, e.g., "Stretching The Fabric Of The Net: Examining the present and potential of peer-to-peer technologies", Software & Information Industry Association (SIIA), 2001. Fig. 5 illustrates the example of a centralized P2P network 502. On P2P network 502 each peer 504, 506, ...508, may make its own logo or graphical representation available for recognition by other peers. This is easier and faster from the user's point of view than is possible with, e.g., network addresses or aliases. In this manner it is easier to spot peers whose recorded content was to the liking of the user on previous occasions so that these preferred peers are going to function as preferred channels easily recognizable by way of their logo. Macros can be installed similarly as with the scenarios of system 100, discussed above, in order to simplify user interaction with device 104 for selecting the proper peer.

## Claims

1. A method of enabling to configure a device for enabling a user to select from among a plurality of sources that supply content, the method comprising:
determining the plurality of sources available to the user for operational use of the device;
determining respective representations of respective ones of the sources for being rendered at a user interface of the device; and
providing means for configuring the device so that user interaction with a specific one of the representations rendered causes the device to select a specific one of the sources associated with the specific representation
**characterized in that**
the determining of the plurality of sources comprises determining, in a network to which the user is connected, a content service provider subscribed to by the user.

2. The method of claim 1, wherein:
the determining of the plurality of sources comprises determining respective identifiers, being local to the user, of respective ones of the plurality of the sources; and
the means is operative to associate the respective representations with the respective identifiers.

3. The method of claim 2, wherein the means comprises a look-up table of associations of the respective local identifiers and the respective representations.

4. The method of claim 2, wherein:
the sources comprise a broadcast channel having a channel number as an associated one of the identifiers; and
a corresponding one of the representations associated with the channel number comprises a logo or call sign of the channel.

5. The method of claim 2, wherein:
the sources comprise a broadcast channel having a channel number as an associated one of the identifiers; and
a corresponding one of the representations associated with the channel number is indicative of semantics of the content broadcast on the channel.

6. The method of claim 1, wherein the determining of the plurality of sources comprises determining in which geographical area the user resides.

## Patentansprüche

1. Verfahren zum Ermöglichen, eine Anordnung zu konfigurieren, damit ein Benutzer aus einer Vielzahl von Quellen, die Inhalt liefern, wählen kann, wobei das Verfahren Folgendes umfasst:
- das Ermitteln der vielen Quellen, die dem Benutzer zur Betreibung der Anordnung zur Verfügung stehen,
- das Ermitteln betreffender Darstellungen betreffender Quellen in einer Benutzerschnittstelle, und
- das Schaffen von Mitteln zum Konfigurieren der Anordnung, so dass die Benutzerschnittstelle mit einer spezifischen gerenderten Darstellung dafür sorgt, dass eine bestimmte mit der spezifischen Darstellung assoziierte Quelle selektiert wird,
**dadurch gekennzeichnet, dass**
die Ermittlung der vielen Quellen das in einem Netzwerk, mit dem der Benutzer verbunden ist, Ermitteln eines Inhaltsdienstproviders, auf den sich der Benutzer abonnieret hat.

2. Verfahren nach Anspruch 1, wobei
- die Ermittlung der vielen Quellen das Ermitteln betreffender, für den Benutzer lokaler Identifizierer von betreffenden Quellen der vielen Quellen umfasst; und
- die Mittel wirksam sind zum Assoziieren der betreffenden Darstellungen mit den betreffenden Identifizieren.

3. Verfahren nach Anspruch 2, wobei die Mittel eine Nachschlagtabelle der Assoziationen der betreffenden lokalen Identifizierer und der betreffenden Darstellungen enthalten.

4. Verfahren nach Anspruch 2, wobei
- die Quellen einen Rundfunkkanal mit einer Kanalnummer als einen assoziierten Identifizierer aufweisen, und
- eine entsprechende mit der Kanalnummer assoziierte Darstellung ein Logo oder ein Rufsignal des Kanals enthält.

5. Verfahren nach Anspruch 2, wobei
- die Quellen einen Rundfunkkanal mit einer Kanalnummer als einen assoziierten Identifizierer aufweisen; und
- eine entsprechende mit der Kanalnummer assoziierte Darstellung eine Anzeige mathematischer Einheiten des über den Kanal gesendeten Inhalts ist.

6. Verfahren nach Anspruch 1, wobei die Ermittlung der vielen Quellen das Ermitteln umfasst, in welchen geographischen Gebiet der Benutzer sich befindet.

## Revendications

1. Procédé destiné à configurer un dispositif pour permettre à un utilisateur d'effectuer une sélection parmi une pluralité de sources fournissant un contenu, le procédé comprenant :
la détermination de la pluralité de sources disponibles pour l'utilisateur en vue d'une utilisation opérationnelle du dispositif;
la détermination de représentations respectives des sources respectives parmi les sources, en vue d'un rendu au niveau d'une interface utilisateur du dispositif, et
la fourniture de moyens destinés à configurer le dispositif, de telle sorte que l'interaction d'utilisateur avec une représentation spécifique parmi celles rendues amène le dispositif à sélectionner une source spécifique parmi celles associées à la représentation spécifique,
**caractérisé en ce que**
la détermination de la pluralité de sources comprend la détermination, sur un réseau auquel l'utilisateur est connecté, d'un fournisseur de services de contenus auquel l'utilisateur est abonné.

2. Procédé suivant la revendication 1, dans lequel
la détermination de la pluralité de sources comprend la détermination d'identificateurs respectifs, de niveau local pour l'utilisateur, de sources respectives parmi la pluralité de sources, et
les moyens fonctionnent de manière à associer les représentations respectives aux identificateurs respectifs.

3. Procédé suivant la revendication 2, dans lequel les moyens comprennent une table à consulter d'associations des identificateurs locaux respectifs avec les représentations respectives.

4. Procédé suivant la revendication 2, dans lequel
les sources comprennent un canal de diffusion qui présente un numéro de canal qui lui est associé comme un des identificateurs, et
une représentation correspondante des représentations, associée au numéro de canal, comprend un logo ou signe d'appel du canal.

5. Procédé suivant la revendication 2, dans lequel
les sources comprennent un canal de diffusion qui présente un numéro de canal qui lui est associé comme un des identificateurs, et
une représentation correspondante des représentations, associée au numéro de canal, est une indication de la sémantique du contenu diffusé sur le canal.

6. Procédé suivant la revendication 1, dans lequel la détermination de la pluralité de sources comprend la détermination de la zone géographique dans laquelle réside l'utilisateur.
